# EUROPEAN PATENT APPLICATION

(11) **EP 4 815 702 A1**
(43) Date of publication of application: **30.09.2026**
(21) Application number: 25896687.8
(22) Date of filing: 27.06.2025
(51) Int. Cl.: H10P 72/00

(54) **SEMICONDUCTOR PROCESSING DEVICE**

(30) Priority: 29.11.2024 CN 202411739606
(71) Applicant: Huaying Research Co., Ltd, Wuxi, Jiangsu 214000 (CN)
(72) Inventor: WANG, Ji, Wuxi, Jiangsu 214000 (CN); WEN, Sophia Ziying, Wuxi, Jiangsu 214000 (CN)
(74) Representative: Sun, Yiming
(86) International application number: PCT/CN2025/104502
(87) International publication number: WO 2026/113388

(57) **Abstract**

The present invention provides a semiconductor processing device, comprising a baseplate, an airbag, a lower fixing-plate, a lower chamber, an upper fixing-plate, an upper chamber, an outer wall, guide posts, a top plate, and a stroke control device, wherein a position of the upper chamber is fixed, and the stroke control device is capable of adjusting a distance between the lower chamber and the upper chamber and maintaining balance of the lower chamber. In the present invention, at least three hemispherical protrusions are adopted to form fulcrums configured to maintain a horizontal state of a top of the lower chamber and prevent the lower chamber from tilting.

## Description

### TECHNICAL FIELD

The present invention relates to the field of semiconductors, and in particular to a semiconductor processing device.

### BACKGROUND

In the existing technology, the chambers used for processing a wafer require the closing of an upper chamber and a lower chamber. The lifting of the lower chamber is achieved by providing an airbag at the bottom of the lower chamber and inflating the airbag to raise the lower chamber. The airbag is used for its advantages such as small size, convenient storage, and high load-bearing capacity. However, the airbag may also bring some defects: during lifting, the top of the airbag may not always remain horizontal, which may cause the lower chamber to tilt when closing, leading to problems such as sealing failure or chamber wear. Moreover, a semi-closed state may be required in actual operation, but it is clear that the stroke of the lower chamber cannot be controlled by the airbag alone.

Therefore, it is necessary to provide a new technical solution.

### SUMMARY

To solve the technical problems in the existing technology, the present invention discloses a semiconductor processing device. The specific technical solution is as follows:
The present invention provides a semiconductor processing device, comprising a baseplate, an airbag, a lower fixing-plate, a lower chamber, an upper fixing-plate, an upper chamber, and a stroke control device,
the position of the upper chamber is fixed, and the stroke control device is capable of adjusting the distance between the lower chamber and the upper chamber while maintaining the balance of the lower chamber.

Preferably, the upper chamber is fixed on the upper fixing-plate, and the position of the upper fixing-plate is fixed,
the lower chamber is fixed on the lower fixing-plate, and the lower chamber is disposed directly below the upper chamber,
the baseplate is disposed below the lower fixing-plate,
the airbag is disposed between the lower fixing-plate and the baseplate, and the airbag, when inflated, lifts the lower fixing-plate upward to close the lower chamber with the upper chamber,
a first end of the stroke control device is fixed on the upper fixing-plate, a second end of the stroke control device extends downward to a point above the lower fixing-plate, and the second ends of all the stroke control device can be both extended and retracted; when the lower fixing-plate is lifted to contact the second end of the stroke control device, the stroke control device adjusts the distance between the lower fixing-plate and the upper fixing-plate by extending and retracting the head of the second end.

Preferably, the stroke control device comprises at least three stroke control devices evenly arranged at an edge of the upper fixing-plate.

Preferably, the stroke control device comprises a telescopic motor, a lever head, and a position sensor,
the telescopic motor is fixed on the upper fixing-plate, a telescopic rod of the telescopic motor extends downward and is fixedly connected to a first end of the lever head, a second end of the lever head extends horizontally outward, the lever head is disposed above the lower fixing-plate, the position sensor is fixed on the upper fixing-plate, and the position sensor detects the position of the second end of the lever head.

Preferably, a plurality of arc-shaped holes are circumstantially spaced at an end portion of the first end of the lever head, and a hemispherical protrusion is disposed at the center of the bottom of the first end of the lever head.

Preferably, the stroke control device further comprises a first bushing, a subplate, and a push rod;
a through-hole is provided on the upper fixing-plate below the telescopic motor, and the telescopic rod extends downward through the through-hole;
the first bushing is disposed within the through-hole, a top edge of the first bushing extends radially outward to form a protruding edge that engages with the top of the upper fixing-plate, and a sealing ring is embedded on the outer side of the first bushing to provide a sealed connection with the upper fixing-plate,
the subplate is disposed above the first bushing, the telescopic motor is disposed above the subplate, and the telescopic motor is connected and fixed to the upper fixing-plate by screws passing through the subplate and the protruding edge of the first bushing,
the push rod is disposed inside the first bushing, and the push rod is fixedly connected to the telescopic rod and the lever head respectively, and a sealing ring is embedded on the outer side of the push rod to provide a sealed connection with the first bushing.

Preferably, it further comprising guide posts,
the guide posts are disposed at the four corners of the baseplate, and the guide posts sequentially pass through the lower fixing-plate and the upper fixing-plate upward, fixing nuts are provided on the guide posts to fix the position of the upper fixing-plate, and the lower fixing-plate is slidably disposed on the guide posts.

The present invention has the following beneficial effects:
1. The semiconductor processing device provided by the present invention has a simple structure, ingenious design, and is easy to manufacture, produce, and retrofit.
2. The semiconductor processing device provided by the present invention adopts at least three hemispherical protrusion structures to form fulcrums, configured to maintain the horizontal state of the top of the lower chamber and prevent the lower chamber from tilting.
3. The semiconductor processing device provided by the present invention adopts the structure of a telescopic motor, enabling active control of the distance between the lower chamber and the upper chamber.

Additional aspects and advantages of the present invention will be partially set forth in the following description, and partially will become apparent from the following description, or may be learned through practice of the present invention.

### BRIEF DESCRIPTION OF THE DRAWINGS

In order to illustrate the embodiments of the present invention or the technical solutions in the existing techniques in a clearer manner, the drawings required for describing the embodiments or the existing techniques will be briefly introduced below. Obviously, the drawings in the following description are merely some embodiments of the present invention. For ordinary technical personnel in this field, other drawings can be obtained based on these drawings without creative effort.
FIG. 1 is a cross-sectional structural schematic view of a semiconductor processing device provided by one embodiment of the present invention.
FIG. 2 is an enlarged structural schematic view of the stroke control device in FIG. 1.

FIG. 3 is a structural schematic view of a lever head of the semiconductor processing device provided by one embodiment of the present invention.

Reference numerals in the drawings are:
Baseplate 10, Airbag 20, Upper fixing-plate 30, Upper chamber 40, Lower fixing-plate 50, Lower chamber 60, stroke control device 70, Guide post 80;
telescopic motor 71, Lever head 72, Position sensor 73, First bushing 74, Subplate 75, Push rod 76, Arc-shaped hole 721, Hemispherical protrusion 722.

### DETAILED DESCRIPTION OF THE PREFERRED EMBODIMENTS

Embodiments of the present invention are described in detail below. Examples of the embodiments are shown in the drawings, wherein the same or similar reference numerals throughout indicate the same or similar elements or elements having the same or similar functions. The embodiments described below with reference to the drawings are exemplary, intended to explain the present invention, and should not be construed as limiting the present invention.

In the description of the present invention, it should be understood that terms such as "upper", "lower", "top", "bottom", "inner", "outer" indicating orientations or positional relationships are based on the orientations or positional relationships shown in the drawings. They are only usde for the convenience in describing the present invention and simplifying the description, and do not indicate or imply that the referred device or element must have a specific orientation, or be constructed and operate in a specific orientation. Therefore, these terms should not be construed as limiting the present invention. In the description of the present invention, "a plurality of" means two or more, unless otherwise explicitly and specifically defined.

In the present invention, unless otherwise explicitly stipulated and defined, terms such as "install", "connect", "couple", "fix" should be understood in a broad sense. For example, it may be a fixed connection, a detachable connection, or an integral formation; it may be a mechanical connection or an electrical connection; it may be a direct connection or an indirect connection through an intermediate medium; it may be an internal communication between two elements or an interaction relationship between two elements. For a person of ordinary skill in the art, the specific meanings of the above terms in the present invention can be understood according to specific circumstances.

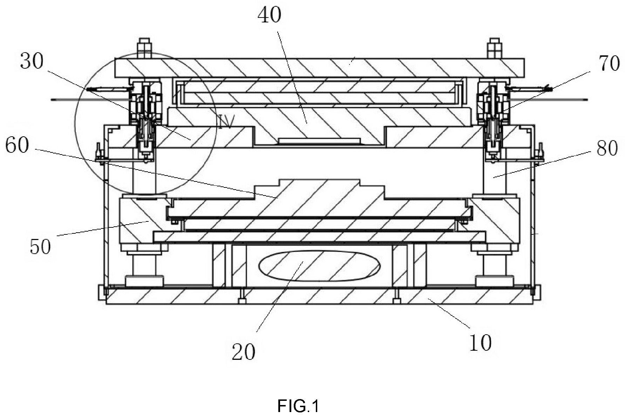

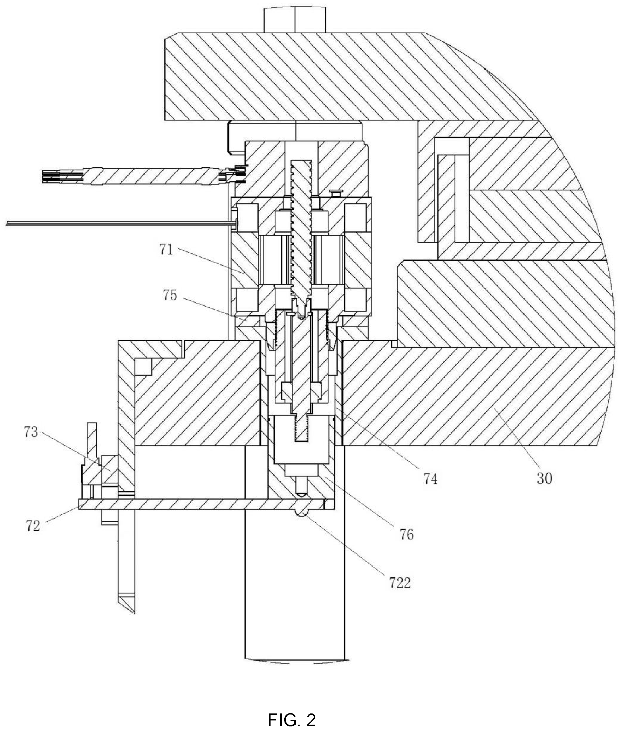

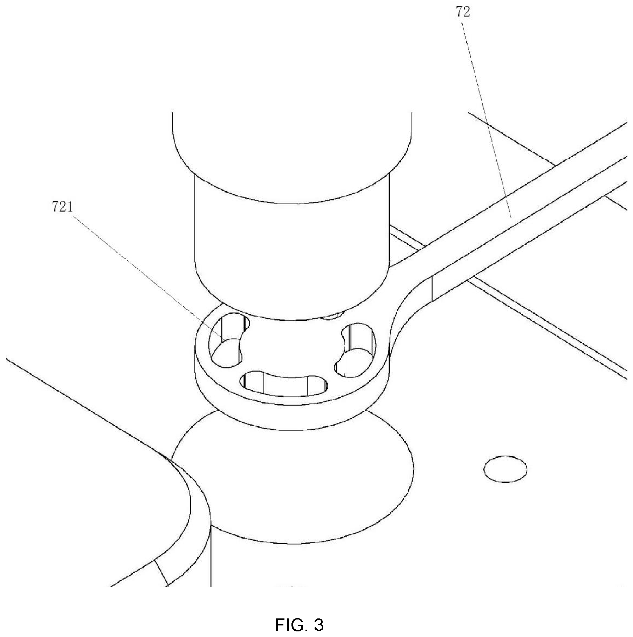

The semiconductor processing device of the present invention, referring to FIG. 1 to FIG. 3, comprises a baseplate 10, an airbag 20, an upper fixing-plate 30, an upper chamber 40, a lower fixing-plate 50, a lower chamber 60, a stroke control device 70, and a guide post 80. The position of the upper chamber 40 is fixed, and the stroke control device 70 is capable of adjusting the distance between the lower chamber 60 and the upper chamber 40 while maintaining the balance of the lower chamber 60.

In one embodiment, the upper chamber 40 is fixed on the upper fixing-plate 30, and the position of the upper fixing-plate 30 is fixed. The lower chamber 60 is fixed on the lower fixing-plate 50, and the lower chamber 60 is disposed directly below the upper chamber 40. The baseplate 10 is disposed below the lower fixing-plate 50. The airbag 20 is disposed between the lower fixing-plate 50 and the baseplate 10, and the airbag 20, when inflated, lifts the lower fixing-plate 50 upward to close the lower chamber 60 with the upper chamber 40.

The first end of the stroke control device 70 is fixed on the upper fixing-plate 30, the second end of the stroke control device 70 extends downward to a point above the lower fixing-plate 50, and the second ends of all the stroke control device 70 can be both extended and retracted; when the lower fixing-plate 50 is lifted to contact the second end of the stroke control device 70, the stroke control device 70 adjusts the distance between the lower fixing-plate 50 and the upper fixing-plate 30 by extending and retracting the end of the second end.

Preferably, the stroke control device 70 comprises at least three stroke control devices evenly arranged at an edge of the upper fixing-plate 30. Specifically, when there are three stroke control devices 70, they are arranged in an equilateral triangle. When there are four stroke control devices 70, they are respectively located at the midpoints of the four sides of the upper fixing-plate 30. When there are eight stroke control devices 70, two stroke control devices 70 are symmetrically arranged at each of the four corners of the upper fixing-plate 30. This ensures that the top of the lower chamber 60 remains horizontal without tilting, allowing for proper closing with the upper chamber 40.

Preferably, the stroke control device 70 comprises a telescopic motor 71, a lever head 72, a position sensor 73, a first bushing 74, a subplate 75, and a push rod 76.

In one embodiment, the telescopic motor 71 is fixed on the upper fixing-plate 30. A telescopic rod of the telescopic motor 71 extends downward and is fixedly connected to a first end of the lever head 72. A second end of the lever head 72 extends horizontally outward. The lever head 72 is disposed above the lower fixing-plate 50. The position sensor 73 is fixed on the upper fixing-plate 30, and the position sensor 73 detects the position of the second end of the lever head 72. Whether each of the lever head 72 is kept horizontal is detected by the position sensor 73, thereby determining whether the lower chamber 60 is kept horizontal. Additionally, the position of the position sensor 73 can be arbitrarily set, for example, it can also be fixed on the side wall, as long as the position of the second end of the lever head 72 can be detected. The second end of the lever head 72 extends horizontally beyond the boundary of the upper fixing-plate 30, facilitating external measurement.

Preferably, a plurality of arc-shaped holes 721 are circumstantially spaced at an end portion of the first end of the lever head 72, and a hemispherical protrusion 722 is disposed at the center of the bottom of the first end of the lever head 72. The arc-shaped holes 721 allow adjustment of the connection position between the lever head and the push rod 76, and the hemispherical protrusion 722 ensures that the contact between the lower fixing-plate 50 and the lever head 72 is point contact, preventing tilting.

In one embodiment, a through-hole is provided on the upper fixing-plate 30 below the telescopic motor 71, and the telescopic rod extends downward through the through-hole. The first bushing 74 is disposed within the through-hole. A top edge of the first bushing 74 extends radially outward to form a protruding edge that engages with the top of the upper fixing-plate 30. A sealing ring is embedded on the outer side of the first bushing 74 to provide a sealed connection with the upper fixing-plate 30. The subplate 75 is disposed above the first bushing 74. The telescopic motor 71 is disposed above the subplate 75, and the telescopic motor 71 is connected and fixed to the upper fixing-plate 30 by screws passing through the subplate 75 and the protruding edge of the first bushing 74. The push rod 76 is disposed inside the first bushing 74, and the push rod 76 is fixedly connected to the telescopic rod and the lever head 72 respectively. A sealing ring is embedded on the outer side of the push rod 76 to provide a sealed connection with the first bushing 74. Double sealing prevents acidic gases from escaping and etching the equipment.

In one embodiment, the guide posts 80 are disposed at the four corners of the baseplate 10, and the guide posts 80 sequentially pass through the lower fixing-plate 50 and the upper fixing-plate 30 upward. Fixing nuts are provided on the guide posts 80 to fix the position of the upper fixing-plate 30, and the lower fixing-plate 50 is slidably disposed on the guide posts 80.

The working principle of the present invention is: a plurality of telescopic motors are set on the upper fixing-plate. The telescopic rods of the telescopic motors pass through the upper fixing-plate and are fixedly connected to one end of the lever heads. The other ends of the lever heads extend beyond the upper fixing-plate. Whether the lower chamber is horizontal or not is determined by detecting, via position sensors, whether the plurality of lever heads are on the same horizontal plane. If not, the corresponding telescopic motors are adjusted to adjust the lower chamber to a horizontal state.

In the description of this specification, descriptions with reference to the terms "one embodiment", "some embodiments", "example", "specific example", or "some examples" mean that specific features, structures, materials, or characteristics described in conjunction with the embodiment or example are included in at least one embodiment or example of the present invention. In this specification, the schematic representations of the above terms do not necessarily refer to the same embodiment or example. Furthermore, the described specific features, structures, materials, or characteristics may be combined in any suitable manner in any one or more embodiments or examples. Additionally, the technical personnel in this field may combine and combine different embodiments or examples described in this specification.

Although the embodiments of the present invention have been shown and described above, it should be understood that the above embodiments are exemplary and should not be construed as limiting the present invention. An ordinary technical personnel in this field may make changes, modifications, alterations, and variations to the above embodiments within the scope of the present invention.

## Claims

1. A semiconductor processing device, **characterized by** comprising: a baseplate, an airbag, a lower fixing-plate, a lower chamber, an upper fixing-plate, an upper chamber, and a stroke control device,
wherein a position of the upper chamber is fixed, and the stroke control device is capable of adjusting a distance between the lower chamber and the upper chamber and maintaining balance of the lower chamber.

2. The semiconductor processing device according to claim 1, **characterized in that**,
the upper chamber is fixed on the upper fixing-plate, and the position of the upper fixing-plate is fixed;
the lower chamber is fixed on the lower fixing-plate, and the lower chamber is disposed directly below the upper chamber;
the baseplate is disposed below the lower fixing-plate;
the airbag is disposed between the lower fixing-plate and the baseplate, and the airbag, when inflated, lifts the lower fixing-plate upward to close the lower chamber with the upper chamber;
a first end of the stroke control device is fixed on the upper fixing-plate, and a second end of the stroke control device extends downward to a point above the lower fixing-plate, and the second ends of all the stroke control devices can be both extended and retracted; when the lower fixing-plate is lifted to contact the second end of the stroke control device, the stroke control device adjusts the distance between the lower fixing-plate and the upper fixing-plate by extending or retracting a head of the second end.

3. The semiconductor processing device according to claim 1, **characterized in that** the stroke control device comprises at least three which are evenly arranged at an edge of the upper fixing-plate.

4. The semiconductor processing device according to claim 1, **characterized in that** the stroke control device comprises a telescopic motor, a lever head, and a position sensor,
the telescopic motor is fixed on the upper fixing-plate, a telescopic rod of the telescopic motor extends downward and is fixedly connected to a first end of the lever head, a second end of the lever head extends horizontally outward, the lever head is disposed above the lower fixing-plate, the position sensor is fixed on the upper fixing-plate, and the position sensor detects the position of the second end of the lever head.

5. The semiconductor processing device according to claim 4, **characterized in that**, a plurality of arc-shaped holes are circumstantially spaced at an end portion of the first end of the lever head, and a hemispherical protrusion is disposed at the center of the bottom of the first end of the lever head.

6. The semiconductor processing device according to claim 4, **characterized in that**, the stroke control device further comprises a first bushing, a subplate, and a push rod;
a through-hole is provided on the upper fixing-plate below the telescopic motor, and the telescopic rod extends downward through the through-hole;
the first bushing is disposed within the through-hole, a top edge of the first bushing extends radially outward to form a protruding edge that engages with the top of the upper fixing-plate, and a sealing ring is embedded on the outer side of the first bushing to provide a sealed connection with the upper fixing-plate;
the subplate is disposed above the first bushing, the telescopic motor is disposed above the subplate, and the telescopic motor is connected and fixed to the upper fixing-plate by screws passing through the subplate and the protruding edge of the first bushing;
the push rod is disposed inside the first bushing, and the push rod is fixedly connected to the telescopic rod and the lever head respectively, and a sealing ring is embedded on the outer side of the push rod to provide a sealed connection with the first bushing.

7. The semiconductor processing device according to claim 2, **characterized by** further comprising guide posts,
the guide posts are disposed at the four corners of the baseplate, and the guide posts sequentially pass through the lower fixing-plate and the upper fixing-plate upward, fixing nuts are provided on the guide posts to fix the position of the upper fixing-plate, and the lower fixing-plate is slidably disposed on the guide posts.
